# EUROPEAN PATENT APPLICATION

(11) **EP 4 797 925 A1**
(43) Date of publication of application: **26.08.2026**
(21) Application number: 25824432.6
(22) Date of filing: 26.02.2025
(51) Int. Cl.: H10K 59/80, H10K 59/12, G09F 9/33

(54) **DISPLAY MODULE AND ELECTRONIC DEVICE**

(30) Priority: 28.06.2024 CN 202410868317
(71) Applicant: HUAWEI TECHNOLOGIES CO., LTD., Shenzhen 518129 (CN)
(72) Inventor: CHEN, Chuyang, Shenzhen, Guangdong 518129 (CN); WANG, Gang, Shenzhen, Guangdong 518129 (CN); HUANG, Yangzheng, Shenzhen, Guangdong 518129 (CN); LIANG, Shuhai, Shenzhen, Guangdong 518129 (CN); ZHOU, Yi, Shenzhen, Guangdong 518129 (CN); CHANG, Yiwen, Shenzhen, Guangdong 518129 (CN); TAN, Jifeng, Shenzhen, Guangdong 518129 (CN); DONG, Yujie, Shenzhen, Guangdong 518129 (CN)
(74) Representative: Huawei European IPR
(86) International application number: PCT/CN2025/079220
(87) International publication number: WO 2026/001037

(57) **Abstract**

This application provides a display module and an electronic device. The display module may be used in the electronic device, and the display module includes a light-emitting layer, an encapsulation layer, a first light transmission layer, a pixel magnification layer, a second light transmission layer, and an anti-glare layer that are stacked in a light-emitting direction. The pixel magnification layer has a first material and a second material, the first material has a first refractive index, the second material has a second refractive index, and a difference between the first refractive index and the second refractive index is a first refractive index difference. A distance between a lower surface of the pixel magnification layer and an upper surface of the light-emitting layer is a first distance, and a product of the first distance and the first refractive index difference ranges from 15 µm to 200 µm. In this application, by limiting a range of the product of the first distance and the first refractive index difference, an equivalent pixel magnification effect of light passing through the pixel magnification layer satisfies a minimum requirement for achieving low display sparkle, thereby achieving high image definition while implementing low sparkle.

## Description

This application claims priority to Chinese Patent Application No. 202410868317.0, filed with the China National Intellectual Property Administration on June 28, 2024 and entitled "DISPLAY MODULE AND ELECTRONIC DEVICE", which is incorporated herein by reference in its entirety.

### TECHNICAL FIELD

This application relates to the field of image display technologies, and more specifically, to a display module and an electronic device.

### BACKGROUND

As the most important terminal human-machine interaction hardware, screens play an irreplaceable role in daily communication and office scenarios. Nowadays, with proliferation of display usage scenarios, consumers start to pay attention to impact of displays on visual health. Reducing visual fatigue caused by viewing a screen with naked eyes has become one of the mainstream design focuses for advanced displays. The mainstream design focuses include a series of display component designs such as low blue light, no sparkle, low reflection, and anti-glare. An anti-glare technology focuses on reducing or eliminating a glare effect caused by specular reflection of ambient light on a screen.

Currently, an anti-glare cover is usually used on a screen to reduce a glare effect caused on the screen. A main function of the anti-glare cover is to achieve diffuse reflection by using a surface microstructure scattering principle. However, the anti-glare cover scatters light emitted by a light-emitting layer. Consequently, uneven light crosstalk occurs between light of different subpixels, causing a visual sparkle problem.

To resolve the sparkle problem, a haze parameter is usually controlled in a process of manufacturing an anti-glare structure of the anti-glare cover, so that the light emitted by the light-emitting layer can have an even light mixing effect to a specific extent. However, this greatly reduces definition of a displayed image. Therefore, a solution of a single anti-glare cover cannot implement low sparkle and high definition at the same time.

### SUMMARY

This application provides a display module and an electronic device, to implement low sparkle while achieving high image definition.

According to a first aspect, a display module is provided. The display module includes a light-emitting layer, an encapsulation layer, a first light transmission layer, a pixel magnification layer, a second light transmission layer, and an anti-glare layer that are stacked in a light-emitting direction. The pixel magnification layer has a first material and a second material, the first material has a first refractive index, the second material has a second refractive index, and a difference between the first refractive index and the second refractive index is a first refractive index difference. A distance between a lower surface of the pixel magnification layer and an upper surface of the light-emitting layer is a first distance, and a product of the first distance and the first refractive index difference ranges from 15 µm to 200 µm.

For example, the pixel magnification layer has an internal refractive index change, and the pixel magnification layer may be made of at least two materials with different refractive indexes. For example, the pixel magnification layer includes the first material and the second material, the first material has the first refractive index, the second material has the second refractive index, and the difference between the first refractive index and the second refractive index is the first refractive index difference. For example, the first refractive index may be a maximum refractive index in the pixel magnification layer, the second refractive index may be a minimum refractive index in the pixel magnification layer, and the first refractive index difference may be a refractive index difference between the maximum refractive index and the minimum refractive index in the pixel magnification layer. For example, a value range of the first refractive index difference may be 0.005 to 0.4. For example, a thickness of the pixel magnification layer ranges from 20 µm to 400 µm.

For example, the light-emitting layer may include a substrate, a drive circuit (for example, a thin film transistor drive circuit), an anode layer, a light-emitting unit, and a cathode layer that are stacked in the light-emitting direction. If an uppermost layer of the light-emitting layer is the cathode layer, the first distance between the lower surface of the pixel magnification layer and the upper surface of the light-emitting layer may be considered as a distance between the lower surface of the pixel magnification layer and an upper surface of the cathode layer of the light-emitting layer.

It should be understood that the pixel magnification layer may mainly reduce sparkle. To be specific, by disposing the pixel magnification layer that has a pixel magnification effect, light emitted by the light-emitting layer is evenly mixed by the pixel magnification layer before entering the anti-glare layer, to reduce a light crosstalk (sparkle) problem caused by the anti-glare layer.

If the pixel magnification layer is excessively far away from the light-emitting layer, an equivalent pixel magnification effect of the pixel magnification layer causes an excessively large pixel image. This can implement lower sparkle, but greatly affects image definition. In contrast, if the pixel magnification layer is excessively close to the light-emitting layer, a pixel magnification effect cannot be achieved. This can ensure definition, but cannot achieve a low sparkle effect. Therefore, a specific optimal placement position of the pixel magnification layer needs to be specified based on an optical effect (mainly represented as an internal refractive index difference Δn) of the pixel magnification layer and a distance (namely, the first distance d) from the pixel magnification layer to the upper surface of the light-emitting layer, to achieve an optimal laminated architecture design. In addition, the optimization design may be changed accordingly based on an effect of the anti-glare layer, to implement a high-definition low-sparkle anti-glare display system design. To achieve an optimal display effect, a specific optical distance is required between the light-emitting layer and the pixel magnification layer, so that optimal screen definition and a sparkle suppression effect can be achieved in such a design.

In embodiments of this application, by adding the pixel magnification layer, sparkle can be reduced. By limiting a range of the product of the first distance and the first refractive index difference to be within a preset range (namely, 15 µm to 200 µm), an equivalent pixel magnification effect of light passing through the pixel magnification layer satisfies a minimum requirement for achieving low display sparkle, without excessively compromising image display definition, thereby achieving high image definition while implementing low sparkle.

With reference to the first aspect, in some implementations of the first aspect, the pixel magnification layer is configured to magnify a pixel, and an area of a magnified pixel is 1.3 times to 3 times of an area of the original pixel. In other words, the area A0 of the original pixel and the area A1 of the pixel obtained through magnification by the pixel magnification layer (or a circumscribed circle of the magnified pixel) satisfy the following relationship: 1.3*A0≤A1≤3*A0.

In embodiments of this application, the pixel magnification layer may be configured to magnify a pixel, in other words, the pixel magnification layer has a pixel magnification effect, and the area of the magnified pixel is 1.3 times to 3 times of the area of the original pixel, so that high image definition can be achieved.

With reference to the first aspect, in some implementations of the first aspect, the first light transmission layer includes a first bonding layer, a first polarizer, and a second bonding layer that are stacked in the light-emitting direction, the first bonding layer is located between the encapsulation layer and the first polarizer, and the second bonding layer is located between the first polarizer and the pixel magnification layer. The first bonding layer and the second bonding layer may be optically clear adhesive.

In embodiments of this application, when a polarizer architecture is used, a polarizer (a circular polarizer or a linear polarizer) may be disposed in the first light transmission layer, and two sides of the polarizer each are fastened to another layer through an bonding layer.

In some possible cases, when the first refractive index difference of the pixel magnification layer is small, to ensure that the range of the product of the first refractive index difference and the first distance is within the preset range, the first distance between the lower surface of the pixel magnification layer and the upper surface of the light-emitting layer needs to be increased, in other words, thicknesses of the encapsulation layer and the first light transmission layer need to be increased. The thickness of the encapsulation layer is usually fixed. Therefore, a multi-layer structure may be disposed in the first light transmission layer to increase the first distance. In this case, a polarizer, a plurality of bonding layers, or another light transmission structure may be disposed in the first light transmission layer, to satisfy a requirement of the first distance.

With reference to the first aspect, in some implementations of the first aspect, the second light transmission layer includes a third bonding layer, a second polarizer, and a fourth bonding layer that are stacked in the light-emitting direction, the third bonding layer is located between the pixel magnification layer and the second polarizer, and the fourth bonding layer is located between the second polarizer and the anti-glare layer. The third bonding layer and the fourth bonding layer may be optically clear adhesive.

In embodiments of this application, when the polarizer architecture is used, a polarizer (a circular polarizer or a linear polarizer) may be disposed in the second light transmission layer, and two sides of the polarizer each are fastened to another layer through an bonding layer.

In some possible cases, an internal structure of the pixel magnification layer is, for example, a grating structure. In this case, a polarizer may be disposed in the second light transmission layer, that is, the polarizer is disposed above the pixel magnification layer, to reduce grating diffraction speckle caused by light passing through the pixel magnification layer.

With reference to the first aspect, in some implementations of the first aspect, the display module further includes a finger touch sensing layer, and the finger touch sensing layer is located between the encapsulation layer and the first light transmission layer.

In embodiments of this application, in the polarizer architecture, the finger touch sensing layer may be disposed between the encapsulation layer and the first light transmission layer, or the finger touch sensing layer may be disposed inside the encapsulation layer. By integrating the finger touch sensing layer into the display module or a display panel, a direct interaction function of a user interface can be implemented.

With reference to the first aspect, in some implementations of the first aspect, the display module further includes a light filter film, and the light filter film is located between the encapsulation layer and the first light transmission layer.

In embodiments of this application, when a color filter on encapsulation technology is used, a conventional polarizer may be replaced with the light filter film (namely, a color film), to improve light-emitting efficiency and a display color gamut of the display module, thereby implementing a low power consumption feature and lightness and thinness.

With reference to the first aspect, in some implementations of the first aspect, the display module further includes a cover and a third light transmission layer. The third light transmission layer is located between the cover and the light filter film, and is configured to bond the cover and the light filter film. The cover is located between the third light transmission layer and the first light transmission layer. For example, the third light transmission layer may be a film layer that has an adhesive function and has specific light transmission.

In embodiments of this application, when the color filter on encapsulation technology is used, the display module may further include the cover and the third light transmission layer. The third light transmission layer may be configured to bond the cover and the light filter film. The cover is located between the third light transmission layer and the first light transmission layer, to implement a protection function.

With reference to the first aspect, in some implementations of the first aspect, both the first light transmission layer and the second light transmission layer are bonding layers configured to bond upper and lower layers. For example, the first light transmission layer and the second light transmission layer may alternatively be other light transmission structure layers that have a specific adhesive effect.

In embodiments of this application, in a color filter on encapsulation architecture, no polarizer needs to be disposed, and the first light transmission layer and the second light transmission layer may be bonding layers configured to bond upper and lower layers. In other words, the first light transmission layer is located between the pixel magnification layer and the encapsulation layer, and is configured to bond the pixel magnification layer and the encapsulation layer; and the second light transmission layer is located between the pixel magnification layer and the anti-glare layer, and is configured to bond the pixel magnification layer and the anti-glare layer.

With reference to the first aspect, in some implementations of the first aspect, an average transmittance haze of the first light transmission layer and/or the second light transmission layer is less than or equal to 5%. It should be understood that the average transmittance haze may be understood as an average value of transmittance hazes.

In embodiments of this application, by limiting the average transmittance haze of the first light transmission layer and the second light transmission layer, light is not excessively scattered when passing through the first light transmission layer and the second light transmission layer, thereby avoiding affecting image definition.

With reference to the first aspect, in some implementations of the first aspect, the display module further includes a finger touch sensing layer, and the finger touch sensing layer is located between the encapsulation layer and the light filter film.

In embodiments of this application, in the color filter on encapsulation architecture, the finger touch sensing layer may be disposed between the encapsulation layer and the light filter film (namely, the color film), or the finger touch sensing layer may be disposed inside the encapsulation layer. By integrating the finger touch sensing layer into the display module or a display panel, a direct interaction function of a user interface can be implemented.

With reference to the first aspect, in some implementations of the first aspect, the display module further includes an anti-reflection layer, and the anti-reflection layer is located on a side that is of the anti-glare layer and that is away from the light-emitting layer.

In embodiments of this application, by disposing the anti-reflection layer on the side that is of the anti-glare layer and that is away from the light-emitting layer, a reflectivity of a surface of a screen can be reduced, so that external light can penetrate the screen or be scattered more when being irradiated on the screen, instead of being directly reflected back to eyes of a viewer. In this way, a specular reflection effect caused by ambient light can be reduced, so that screen content is clearer in various lighting conditions.

With reference to the first aspect, in some implementations of the first aspect, the display module further includes an oleophobic coating, and the oleophobic coating is located on the side that is of the anti-glare layer and that is away from the light-emitting layer.

In embodiments of this application, the oleophobic coating is disposed on the side that is of the anti-glare layer and that is away from the light-emitting layer, to implement anti-fingerprint and easy cleaning of the screen, improve a touch sense of the screen, protect the screen, and prolong a service life of the screen.

With reference to the first aspect, in some implementations of the first aspect, the light-emitting layer includes a plurality of light-emitting units, and the plurality of light-emitting units use a tandem design.

In embodiments of this application, the light-emitting units in the light-emitting layer may use a conventional single component (namely, single component) technology, or may use a tandem light-emitting unit design (for example, a Tandem component technology). The Tandem component technology is to connect a plurality of component units (for example, RGB light-emitting units) with similar functions in series to form a multi-layer stacked structure. In such a design, a plurality of light-emitting layers may be stacked to improve overall performance of an OLED component, thereby increasing brightness, prolonging a service life, reducing power consumption, or the like.

With reference to the first aspect, in some implementations of the first aspect, the anti-glare layer includes an anti-glare substrate and an anti-glare structure, and the anti-glare substrate is located between the second light transmission layer and the anti-glare structure.

In embodiments of this application, the anti-glare layer changes a physical characteristic of the surface of the screen, so that the screen has a specific diffuse reflection effect, to disperse reflected light and reduce a glare effect caused by direct light. In this way, even in a strong light environment, visual interference caused by screen reflection to a user can be reduced, to improve visibility.

In some possible cases, the anti-glare structure may be formed through processing on the anti-glare substrate. The anti-glare structure has a tiny concave-convex texture, and therefore has a specific diffuse reflection effect, to reduce a glare effect caused by direct light.

With reference to the first aspect, in some implementations of the first aspect, a surface of the anti-glare layer is uneven, roughness of the anti-glare layer ranges from 100 nm to 350 nm, and a thickness of the anti-glare layer ranges from 5 µm to 5000 µm.

In embodiments of this application, the anti-glare layer may be an uneven structure that is formed on a surface of glossy glass through chemical etching or the like, so that the anti-glare layer has a specific diffuse reflection effect, to reduce a glare effect caused by direct light.

With reference to the first aspect, in some implementations of the first aspect, a transmittance of the anti-glare layer is greater than or equal to 85%, and an average transmittance haze of the anti-glare layer ranges from 5% to 35%. It should be understood that the average transmittance haze may be understood as an average value of transmittance hazes.

In embodiments of this application, by limiting the average transmittance haze and the transmittance of the anti-glare layer, light is not excessively scattered when passing through the anti-glare layer, thereby avoiding affecting image definition.

With reference to the first aspect, in some implementations of the first aspect, a surface of the anti-glare layer is even, the anti-glare layer is doped with particles inside, an average particle size of the doped particles inside the anti-glare layer ranges from 200 nm to 2000 nm, and a thickness of the anti-glare layer ranges from 1000 nm to 5000 nm.

In embodiments of this application, the anti-glare layer may be a structure having an even or basically even surface but doped with particles inside. The doped particles inside the anti-glare layer may be metal or a metal oxide, or may be an organic polymer. In this case, the anti-glare layer can also reduce the glare effect caused by direct light. Even in the strong light environment, visual interference caused by screen reflection to the user can be reduced, to improve visibility.

According to a second aspect, an electronic device is provided. The electronic device includes the display module according to any one of the first aspect and the implementations of the first aspect.

It should be understood that, when the electronic device uses the display module according to the first aspect, low sparkle can be implemented while high image definition is achieved.

### BRIEF DESCRIPTION OF DRAWINGS

FIG. 1A and FIG. 1B are cross-sectional views of two anti-glare covers according to this application;
FIG. 2 is a cross-sectional view of a display module according to an embodiment of this application;
FIG. 3 is a cross-sectional view of another display module according to an embodiment of this application;
FIG. 4 is a cross-sectional view of another display module according to an embodiment of this application;
FIG. 5 is a cross-sectional view of another display module according to an embodiment of this application;
FIG. 6A to FIG. 6C are diagrams of a scattering light type of a pixel magnification layer according to an embodiment of this application;
FIG. 7 is a cross-sectional view of another display module according to an embodiment of this application;
FIG. 8 is a computational reference diagram of an anti-glare capability indicator BRDF according to an embodiment of this application;
FIG. 9 is a cross-sectional view of another display module according to an embodiment of this application;
FIG. 10 is a cross-sectional view of another display module according to an embodiment of this application;
FIG. 11 is a cross-sectional view of another display module according to an embodiment of this application; and
FIG. 12 is a cross-sectional view of another display module according to an embodiment of this application.

### DESCRIPTION OF EMBODIMENTS

The following describes technical solutions in this application with reference to accompanying drawings.

In embodiments of this application, terms "first" and "second" are used merely for a purpose of description, and shall not be construed as indicating or implying relative importance or implying a quantity of indicated technical features. Therefore, a feature limited by "first " or "second" may explicitly indicate or implicitly include one or more such features. In addition, in the descriptions of embodiments of this application, "a plurality of" means two or more, and "at least one" and "one or more" mean one, two, or more. The singular expression forms "one", "a", "the", "the foregoing", "this", and "the one" are also intended to include an expression form like "one or more", unless the opposite is explicitly indicated in the context thereof. Sequence numbers of the following processes do not mean an execution sequence. The execution sequence of the processes should be determined based on functions and internal logic of the processes, and should not constitute any limitation on an implementation process of embodiments of this application. For example, in embodiments of this application, the terms "110", "120", "130", and the like are merely identifiers for ease of description, and are not intended to limit an execution sequence of steps.

Reference to "an embodiment", "some embodiments", or the like described in this specification means that a specific feature, structure, or characteristic described with reference to the embodiment is included in one or more embodiments of this application. Therefore, statements such as "in an embodiment", "in some embodiments", "in some other embodiments", and "in other embodiments" that appear at different places in this specification do not necessarily mean referring to a same embodiment, but mean "one or more but not all of embodiments", unless otherwise specifically emphasized in another manner. The terms "include", "have", and their variants all mean "include but are not limited to", unless otherwise specifically emphasized in another manner.

In the descriptions of embodiments of this application, an orientation or a position relationship indicated by the term "up", "down", "inside", "outside", or the like is defined relative to an orientation or a position at which a component is schematically placed in the accompanying drawings. It should be understood that these directional terms are relative concepts, and are used for relative description and clarification instead of indicating or implying that a specified apparatus or component needs to have a specific orientation or be constructed and operated in a specific orientation. These direction terms may vary based on changes of orientations of the components in the accompanying drawings, and therefore cannot be understood as a limitation on this application.

It should be noted that a distance between a first surface and a second surface in embodiments of this application may be understood as a vertical distance between a horizontal plane on which the first surface is located and a horizontal plane on which the second surface is located. The vertical herein is equivalent to a thickness direction of a laminated layer. If a first plane and/or a second plane are/is not an even surface, a distance between the first plane and the second plane may be understood as a vertical distance between a highest point of the first plane and a highest point of the second plane, or may be understood as a vertical distance between a lowest point of the first plane and a lowest point of the second plane, or may be understood as a vertical distance between a central point (namely, a midpoint between the highest point and the lowest point) of the first plane and a central point (namely, a midpoint between the highest point and the lowest point) of the second plane.

As the most important terminal human-machine interaction hardware, screens play an irreplaceable role in daily communication and office scenarios. As a display component, a main function of the screen is to effectively display information. Based on this, a series of technical development directions have been expanded. For example, on mobile phones, higher resolution, richer color display, and lower power consumption have become mainstream screen technology pursuits. In addition, besides quality of the screen, different terminal component design strategies emerge for application scenarios. For example, when a privacy protection function is emphasized, a film layer whose light transmittance can change with a viewing angle is additionally mounted on the screen, so that a screen that has a screen privacy effect can be obtained. Nowadays, with proliferation of display usage scenarios, consumers start to pay attention to impact of displays on visual health. Reducing visual fatigue caused by viewing a screen with naked eyes has become one of the mainstream design focuses for advanced displays. The mainstream design focuses include a series of display component designs such as low blue light, no sparkle, low reflection, and anti-glare, and focus on a core design concept of healthy use of display components by users. An anti-glare technology focuses on reducing or eliminating a glare effect caused by specular reflection of ambient light on a screen. For a point light source (for example, lamplight or sunlight) in daily life, extremely high light source brightness is not suitable for direct viewing or indirect viewing (for example, through specular reflection) by human eyes. In addition, the anti-glare technology also directly affects performance of a screen image (for example, text definition of the image in a display-on state). Therefore, development of the anti-glare technology needs to take management of the reflected ambient light and management of light emitted by a pixel into consideration. According to technical requirements, conditions for implementing anti-glare include management of light emitted by the screen and management of ambient light reflected by the screen.

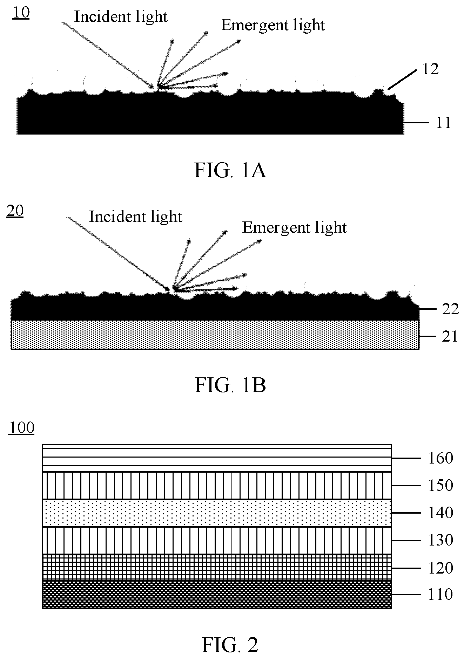

Currently, an anti-glare cover is usually used on a screen to reduce a glare effect caused on the screen. As shown in FIG. 1A and FIG. 1B, the anti-glare cover may be classified into a glass anti-glare cover 10 and a composite material anti-glare cover 20. In some examples, as shown in FIG. 1A, the glass anti-glare cover 10 is based on glossy glass 11, and a microstructure morphology (namely, an anti-glare structure 12) is obtained on a surface of the glossy glass 11 through chemical etching or the like. The anti-glare structure 12 usually appears in an irregular arrangement form, causing light incident to a surface of the glass anti-glare cover 10 to be scattered. In other words, incident light incident to the anti-glare structure 12 of the glass anti-glare cover 10 is scattered to different degrees, and emergent light may be emitted at different angles. In some other examples, as shown in FIG. 1B, the composite material anti-glare cover 20 is based on a thermoplastic material, and is prepared with an anti-glare structure on a surface by combining two different materials through hot-pressing. For example, the composite material anti-glare cover 20 may include an anti-glare substrate 21 and an anti-glare structure 22. The anti-glare substrate 21 may be made of a polymethyl methacrylate (polymethyl methacrylate, PMMA) material, and the anti-glare structure 22 may be made of a polycarbonate (polycarbonate, PC) material. For example, the PC may be hot-pressed on the PMMA through nanoimprinting. In this way, the anti-glare structure 22 formed on the surface of the composite material anti-glare cover 20 may cause diffuse reflection of incident light. In other words, incident light incident to the anti-glare structure 22 of the composite material anti-glare cover 20 is scattered to different degrees, and emergent light may be emitted at different angles.

It should be understood that a main function of the anti-glare cover is to achieve diffuse reflection by using a surface microstructure scattering principle. However, this structure (namely, the anti-glare structure) also scatters light emitted by a display panel (or a light-emitting layer). Consequently, uneven light crosstalk occurs between light of different subpixels, causing a visual sparkle problem.

Light (including red, green, and blue light) emitted by the display panel (or the light-emitting layer) is scattered when passing through an uneven microstructure of the anti-glare cover. The anti-glare structure on the surface of the anti-glare cover causes irregular scattering of pixel light, thereby causing crosstalk between the red, green, and blue light. Such scattering eventually leads to a visual perception of visible bright and dark granular grains in a display image, and is visually presented as blinking speckle (namely, sparkle) that changes with a viewing angle. The sparkle problem is particularly prominent on an organic light-emitting diode (organic light-emitting diode, OLED) display. A reason is that an OLED display technology has a lower pixel opening ratio than a conventional liquid crystal display (liquid crystal display, LCD) technology. As a result, a severer sparkle problem occurs on the OLED display with an anti-glare solution using a random surface structure.

To resolve the sparkle problem, a haze parameter is usually controlled in a process of manufacturing an anti-glare structure of the anti-glare cover (a haze describes one of physical properties of emergent light after light passes through a medium and is scattered). The haze is defined as a percentage of strength of transmitted light that deviates from incident light by 2.5° or more in total transmitted light strength. A larger haze indicates a lower transparency/imaging degree, so that light emitted by the display panel (or the light-emitting layer) can have an even light mixing effect to a specific extent. However, this greatly reduces definition of a displayed image. Therefore, a solution of a single anti-glare cover cannot implement low sparkle and high definition at the same time.

To resolve the foregoing problem, embodiments of this application provide a display module and an electronic device, to implement low sparkle while achieving high image definition.

The following describes in detail a cross-sectional view of the display module according to embodiments of this application with reference to FIG. 2 to FIG. 10.

It should be noted that the display module provided in embodiments of this application may be used in the electronic device. The display module may be, for example, a liquid crystal display (liquid crystal display, LCD), an organic light-emitting diode (organic light-emitting diode, OLED), or an LED. The electronic device may include an apparatus having a display, for example, a mobile phone, a display, a large-screen television, or a tablet computer. The electronic device may have high resolution, for example, may be a mainstream 2K, 4K, or 8K display. A pixel density (pixels per inch, PPI) of the electronic device may be a low PPI (<200) or a high PPI (≥200, ≥250, ≥300, ≥350, ≥400, ≥450, and ≥500).

As shown in FIG. 2, the display module 100 may include a light-emitting layer 110, an encapsulation layer 120, a first light transmission layer 130, a pixel magnification layer 140, a second light transmission layer 150, and an anti-glare layer 160. The light-emitting layer 110, the encapsulation layer 120, the first light transmission layer 130, the pixel magnification layer 140, the second light transmission layer 150, and the anti-glare layer 160 are stacked in a light-emitting direction. Specifically, the light-emitting layer 110 may be disposed at the bottom, the encapsulation layer 120 may be disposed on the light-emitting layer 110, the first light transmission layer 130 may be disposed on a side that is of the encapsulation layer 120 and that is away from the light-emitting layer 110, the pixel magnification layer 140 may be disposed on a side that is of the first light transmission layer 130 and that is away from the encapsulation layer 120, the second light transmission layer 150 may be disposed on a side that is of the pixel magnification layer 140 and that is away from the first light transmission layer 130, and the anti-glare layer 160 is disposed at the top, in other words, the anti-glare layer 160 may be disposed on a side that is of the second light transmission layer 150 and that is away from the pixel magnification layer 140. Light emitted by the light-emitting layer 110 may pass through the encapsulation layer 120, the first light transmission layer 130, the pixel magnification layer 140, the second light transmission layer 150, and the anti-glare layer 160, and is finally observed by human eyes.

For example, the pixel magnification layer 140 has an internal refractive index change, and the pixel magnification layer 140 may be made of at least two materials with different refractive indexes. For example, the pixel magnification layer 140 includes a first material and a second material, the first material has a first refractive index, the second material has a second refractive index, and a difference between the first refractive index and the second refractive index is a first refractive index difference. For example, the first refractive index may be a maximum refractive index in the pixel magnification layer 140, the second refractive index may be a minimum refractive index in the pixel magnification layer 140, and the first refractive index difference may be a refractive index difference between the maximum refractive index and the minimum refractive index in the pixel magnification layer 140. For example, a value range of the first refractive index difference may be 0.005 to 0.4.

It should be understood that a distance between a lower surface of the pixel magnification layer 140 and an upper surface of the light-emitting layer 110 is a first distance, and a product of the first distance and the first refractive index difference ranges from 15 µm to 200 µm.

It should be understood that in this application, by adding the pixel magnification layer 140, sparkle can be reduced. By limiting a range of the product of the first distance and the first refractive index difference, an equivalent pixel magnification effect of light passing through the pixel magnification layer 140 satisfies a minimum requirement for achieving low display sparkle, without excessively compromising image display definition, thereby achieving high image definition while implementing low sparkle.

The light-emitting layer 110 is mainly configured to emit light, for example, emit red, green, and blue light. The light-emitting layer 110 may include a substrate, a drive circuit (for example, a thin film transistor drive circuit), an anode layer, a light-emitting unit, a cathode layer, and the like that are stacked. The light-emitting unit may include a plurality of pixel light-emitting units arranged in an array, each pixel light-emitting unit includes at least three subpixel light-emitting units (for example, RGB light-emitting units), and each subpixel light-emitting unit may display light of one color. For example, each pixel light-emitting unit may include three subpixel light-emitting units, which are respectively a red subpixel light-emitting unit (namely, a red light-emitting layer) that can display (emit) red light, a green subpixel light-emitting unit (namely, a green light-emitting layer) that can display green light, and a blue subpixel light-emitting unit (namely, a blue light-emitting layer) that can display blue light. For a specific structure of the light-emitting layer 110, refer to existing structures of an LCD, an OLED, and an LED. Details are not described herein.

It should be noted that, in embodiments of this application, the light-emitting units in the light-emitting layer 110 may use a conventional single component (namely, single component) technology, or may use a tandem light-emitting unit design (for example, a Tandem component technology) to increase light-emitting intensity. This is not limited in this application.

It should be understood that the Tandem component technology usually refers to a structure design method used in the field of electronic components (for example, OLEDs), to connect a plurality of component units (for example, RGB light-emitting units) with similar functions in series to form a multi-layer stacked structure. In such a design, a plurality of light-emitting layers may be stacked to improve overall performance of an OLED component, thereby increasing brightness, prolonging a service life, reducing power consumption, or the like. For specific descriptions of the Tandem component technology, refer to the conventional technology. Details are not described herein in this application.

The encapsulation layer 120 may be a thin film encapsulation (thin film encapsulation, TFE) layer or a conventional glass encapsulation layer. The encapsulation layer 120 may mainly protect the light-emitting layer 110. The encapsulation layer 120 may be made of a glass material. For example, an encapsulation layer in a display of a tablet computer may be made of a glass material. The encapsulation layer 120 may alternatively be made of an organic polymer material (for example, a colorless polyimide (colorless polyimide, CPI) film, a high-temperature-resistant polyethylene terephthalate (polyethylene terephthalate, PET) film, or a triacetyl cellulose (triacetyl cellulose, TAC) film). For example, an encapsulation layer in a foldable display or an ultra-thin display may be made of the organic polymer material.

The first light transmission layer 130 and the second light transmission layer 150 are respectively disposed on two sides of the pixel magnification layer 140, and the first light transmission layer 130 and the second light transmission layer 150 are film layers having an average transmittance haze less than or equal to 5%. It should be understood that the average transmittance haze may be understood as an average value of transmittance hazes. The transmittance haze is a degree of scattering that occurs when light passes through an object. When light passes through a material, the light interacts with tiny unevenness inside the material, resulting in light scattering. A higher transmittance haze indicates a stronger light scattering capability of the material and more blurred transmitted light. In contrast, a lower transmittance haze indicates a weaker light scattering capability of the material and clearer transmitted light.

By limiting the average transmittance haze of the first light transmission layer 130 and the second light transmission layer 150, light is not excessively scattered when passing through the first light transmission layer 130 and the second light transmission layer 150, thereby avoiding affecting image definition.

It should be understood that the first light transmission layer 130 and the second light transmission layer 150 may be of a single-layer structure, or may be of a multi-layer structure. For example, the first light transmission layer 130 and the second light transmission layer 150 may be bonding layers configured to bond upper and lower layers. For another example, the first light transmission layer 130 and the second light transmission layer 150 each may include a polarizer configured to filter polarization of light. For another example, the first light transmission layer 130 and the second light transmission layer 150 may be other optical film layers that do not have a strong scattering effect (an average transmittance haze of the optical film layers is less than or equal to 5%).

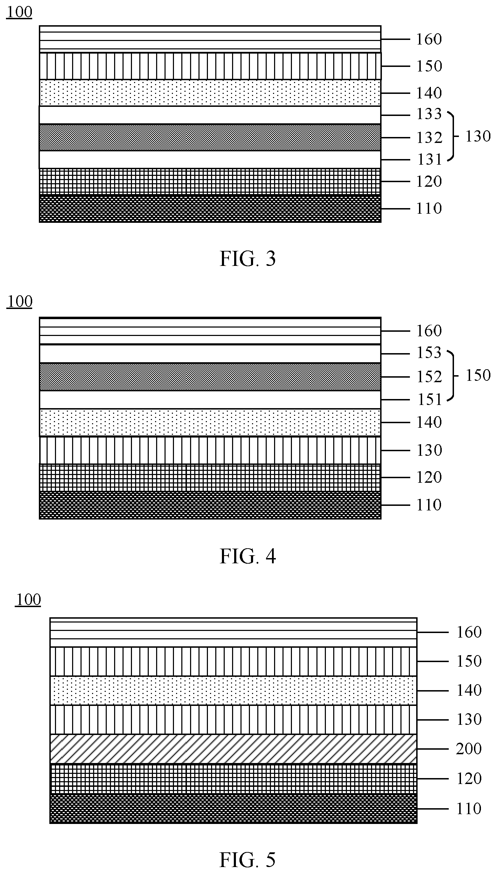

In some embodiments, as shown in FIG. 3, if a polarizer (polarizer, POL) architecture is used, the first light transmission layer 130 may include an bonding layer 131, a polarizer 132, and an bonding layer 133. The polarizer 132 may be configured to filter the polarization of light. The bonding layer 131 is located between the encapsulation layer 120 and the polarizer 132, and is configured to bond the encapsulation layer 120 and the polarizer 132. The bonding layer 133 is located between the polarizer 132 and the pixel magnification layer 140, and is configured to bond the polarizer 132 and the pixel magnification layer 140. The polarizer 132 may be a linear polarizer or a circular polarizer. This is not limited in this application.

It should be understood that, in some possible cases, when the first refractive index difference of the pixel magnification layer 140 is small, to implement low sparkle while achieving high image definition, the range of the product of the first refractive index difference and the first distance needs to be limited to be within a preset range, and the first distance between the lower surface of the pixel magnification layer 140 and the upper surface of the light-emitting layer 110 needs to be increased, in other words, thicknesses of the encapsulation layer 120 and the first light transmission layer 130 need to be increased. Therefore, a multi-layer structure may be disposed in the first light transmission layer 130 to increase the first distance. In this case, a polarizer, a plurality of bonding layers, or another light transmission structure may be disposed in the first light transmission layer 130, to satisfy a requirement of the first distance.

In some embodiments, as shown in FIG. 4, if a POL architecture is used, the second light transmission layer 150 may include an bonding layer 151, a polarizer 152, and an bonding layer 153. The polarizer 152 may be configured to filter the polarization of light. The bonding layer 151 is located between the pixel magnification layer 140 and the polarizer 152, and is configured to bond the pixel magnification layer 140 and the polarizer 152. The bonding layer 153 is located between the polarizer 152 and the anti-glare layer 160, and is configured to bond the polarizer 152 and the anti-glare layer 160. The polarizer 152 may be a linear polarizer or a circular polarizer. This is not limited in this application.

It should be understood that, in some possible cases, an internal structure of the pixel magnification layer 140 is, for example, a grating structure. In this case, a polarizer is disposed in the second light transmission layer 150, that is, the polarizer is disposed above the pixel magnification layer 140, to reduce grating diffraction speckle caused by the pixel magnification layer 140.

For example, the bonding layer 131, the bonding layer 133, the bonding layer 151, and the bonding layer 153 may all be optically clear adhesive (optically clear adhesive, OCA).

In some embodiments, in the POL architecture, the display module 100 may further include a finger touch sensing layer (finger touch sensing layer), and the finger touch sensing layer is located between the encapsulation layer 120 and the first light transmission layer 130. It should be understood that the finger touch sensing layer is integrated into the display panel by using a precise circuit design and a signal processing technology, to implement a direct interaction function of a user interface.

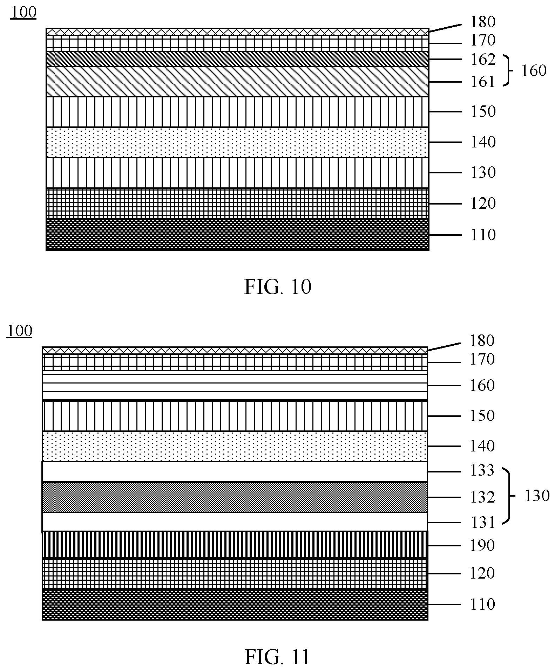

The POL architecture of the display module is described in detail with reference to FIG. 11.

In some embodiments, the display module 100 may use a color filter on encapsulation (color filter on encapsulation, CoE) architecture. The CoE architecture uses a color filter (color filter, CF) architecture to replace a conventional polarizer architecture, to improve light-emitting efficiency and a display color gamut of the display module, thereby implementing a low power consumption feature and lightness and thinness.

For example, as shown in FIG. 5, if the CoE architecture is used, the display module 100 may further include a light filter film 200. The light filter film 200 may be disposed between the encapsulation layer 120 and the first light transmission layer 130. It should be understood that the light filter film 200 may be referred to as a light filter, a color light filter, or the like.

As described above, each pixel usually includes three subpixels: red, green, and blue (RGB). Therefore, each subpixel needs to have a light filter film of a corresponding color. These light filter films each allow light of a specific color to pass through and block light of other colors, thereby forming rich colors during combination. In other words, the light filter film 200 may be classified into a red light filter, a green light filter, and a blue light filter. The red light filter corresponds to a red light-emitting unit, the green light filter corresponds to a green light-emitting unit, and the blue light filter corresponds to a blue light-emitting unit, so that light of a specific color passes through, to help enhance contrast and color saturation of a displayed image, and make a displayed color brighter and more authentic.

It should be noted that, in the CoE architecture, the first light transmission layer 130 and the second light transmission layer 150 may be bonding layers configured to bond upper and lower layers. In other words, the first light transmission layer 130 is located between the pixel magnification layer 140 and the encapsulation layer 120, and is configured to bond the pixel magnification layer 140 and the encapsulation layer 120; and the second light transmission layer 150 is located between the pixel magnification layer 140 and the anti-glare layer 160, and is configured to bond the pixel magnification layer 140 and the anti-glare layer 160.

For example, the first light transmission layer 130 and the second light transmission layer 150 may alternatively be other light transmission structure layers that have a specific adhesive effect. This is not limited in this application.

In some examples, in the CoE architecture, the display module 100 may further include a cover and a third light transmission layer. The third light transmission layer is located between the cover and the light filter film, and may be configured to bond the cover and the light filter film 200. The cover is located between the third light transmission layer and the first light transmission layer 130.

In some embodiments, in the CoE architecture, the display module 100 may further include a finger touch sensing layer, and the finger touch sensing layer is located between the encapsulation layer 120 and the light filter film 200.

For example, in the CoE architecture, the first light transmission layer 130, the second light transmission layer 150, and the third light transmission layer may all be optically clear adhesive (optically clear adhesive, OCA).

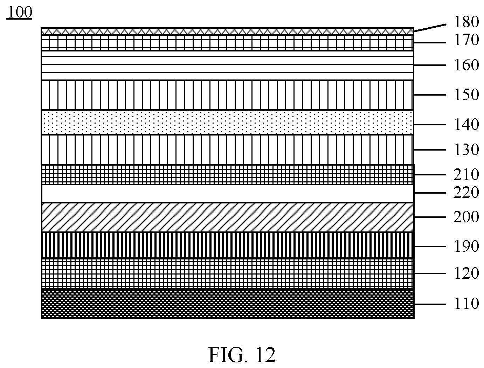

The CoE architecture of the display module is described in detail with reference to FIG. 12.

The pixel magnification layer 140 is located between the first light transmission layer 130 and the second light transmission layer 150, and may mainly reduce sparkle. To be specific, by disposing an optical film that has a pixel magnification effect, light emitted by the light-emitting layer is evenly mixed by the film before entering an anti-glare structure, to reduce a light crosstalk (sparkle) problem caused by the anti-glare structure. Specifically, the pixel magnification layer 140 mainly achieves even scattering of incident light through some scattering structures, and achieves a pixel imaging magnification effect in an optical manner, so that a space proportion of the red, green, and blue subpixels is large, a pixel spacing is small, and a pixel opening rate is increased, to reduce a display sparkle problem caused by optical scattering of an irregular microstructure of the anti-glare layer 160.

It should be understood that the pixel magnification layer 140 may be a pixel magnification film with a specific internal refractive index difference. The refractive index difference causes a change in a propagation direction of light when the light passes through the film and encounters refractive indexes of different materials. Different interface shape structures lead to different direction change manners, thereby causing scattering corresponding to the structure. An optical scattering effect is achieved through the internal refractive index difference, thereby achieving pixel magnification in imaging.

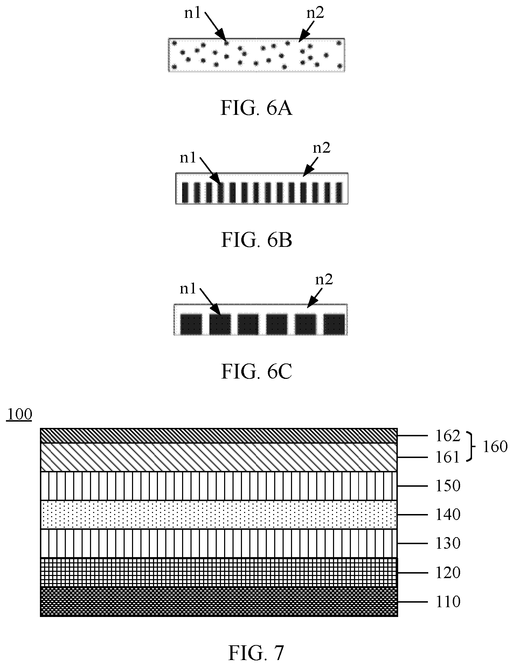

FIG. 6A to FIG. 6C show scattering light types of three different types of pixel magnification layers. As shown in FIG. 6A to FIG. 6C, the pixel magnification layer 140 may be made of at least two materials with different refractive indexes (for example, a first material and a second material). The formed pixel magnification layer may be a pixel magnification layer of a doped particle type (as shown in FIG. 6A), or may be a pixel magnification layer of a closely arranged optical fiber type (as shown in FIG. 6B), or may be a pixel magnification layer of a loosely arranged grating type (as shown in FIG. 6C).

In some examples, as shown in FIG. 6A, the pixel magnification layer 140 may be a pixel magnification layer of a doped particle type. In other words, the pixel magnification layer 140 may be formed by mixing scattering particles in a thin film base material. A refractive index of the thin film base material (namely, the first material) is n2, and a refractive index of the mixed scattering particles (namely, the second material) is n1.

In some examples, as shown in FIG. 6B, the pixel magnification layer 140 may be a pixel magnification layer of a closely arranged optical fiber type. In other words, the pixel magnification layer 140 may be formed by adding closely arranged optical fibers to a thin film base material. A refractive index of the thin film base material (namely, the first material) is n2, and a refractive index of the closely arranged optical fibers (namely, the second material) is n1.

In some examples, as shown in FIG. 6C, the pixel magnification layer 140 may be a pixel magnification layer of a loosely arranged grating type. In other words, the pixel magnification layer 140 may be formed by adding loosely arranged gratings to a thin film base material. A refractive index of the thin film base material (namely, the first material) is n2, and a refractive index of the loosely arranged gratings (namely, the second material) is n1.

The pixel magnification layer 140 has an internal refractive index change, and the pixel magnification layer 140 may be made of at least two materials with different refractive indexes. For example, the pixel magnification layer 140 includes a first material and a second material, the first material has a first refractive index, the second material has a second refractive index, and a difference between the first refractive index and the second refractive index is a first refractive index difference. For example, the first refractive index may be a maximum refractive index in the pixel magnification layer 140, the second refractive index may be a minimum refractive index in the pixel magnification layer 140, and the first refractive index difference may be a refractive index difference between the maximum refractive index and the minimum refractive index in the pixel magnification layer 140. For example, a value range of the first refractive index difference may be 0.005 to 0.4.

For example, the first refractive index difference may be denoted as Δn, where Δn=|n1-n2|, 0.005≤Δn≤0.4, n1 may be the maximum refractive index or the minimum refractive index in the pixel magnification layer 140, n2 may be the minimum refractive index or the maximum refractive index in the pixel magnification layer 140, and Δn is the difference between the maximum refractive index and the minimum refractive index in the pixel magnification layer 140.

It should be understood that the pixel magnification layer 140 is usually a thin film with an internal refractive index difference formed by disposing two or more types of materials (different materials have different refractive indexes) inside the thin film, namely, a base material (a thin film) and a scattering material (for example, a particle or a grating). For example, the pixel magnification layer 140 may be implemented in the following manners:

In an implementation, materials (usually polymer materials in a liquid state) that originally have different refractive indexes may be mixed (usually, one has a high refractive index, and the other has a low refractive index), and an even mixed layer with a specific thickness is formed on a base material through coating or the like. The base material may be a plastic film like polyethylene terephthalate (polyethylene terephthalate, PET) or tri-acetyl cellulose (tri-acetyl cellulose, TAC), or may be a hard base material like glass or ultra thin glass (ultra thin glass, UTG). Through ultraviolet (ultraviolet, UV) exposure or thermal curing, the high-refractive-index material is automatically polymerized and cured to form a specific three-dimensional structure pattern. The pattern may be periodic or aperiodic. A microstructure in the pattern may be continuous or discontinuous, and may be regular or irregular. This is not limited. The remaining low-refractive-index material may be cured through further processing. In this way, an optical film (namely, the pixel magnification layer 140) in which the cured high-refractive-index material with the specific pattern is wrapped by the surrounding low-refractive-index material is obtained. Such a thin film can have different optical effects based on a refractive index difference, a structure pattern, and an overall thickness.

In another implementation, the optical film (namely, the pixel magnification layer 140) with the internal refractive index difference may be obtained through imprinting. First, an imprint mold is prepared, and a surface of the mold has a specific pattern (for example, a periodic or aperiodic structure). After a material with a specific refractive index is coated on a base material, a structural morphology is transferred to the material through mold imprinting, and then the pattern is retained on the material by using a curing process (UV irradiation or thermal curing). Finally, after the material is peeled off a template, a material with another refractive index (for example, a low-refractive-index or high-refractive-index photoresist) is coated on a surface of the pattern, and a gap formed through patterning is filled, to finally obtain the pixel magnification layer of the grating type shown in FIG. 6C.

It should be understood that the pixel magnification layer 140 with the internal refractive index difference may be obtained in another processing manner in this application. The foregoing implementation is merely an example for description, and should not constitute a limitation on the processing manner of the pixel magnification layer 140 in this application.

It should be noted that, regardless of which manner is used to implement a pixel magnification film, the pixel magnification film essentially scatters incident light. In terms of a display effect, an optical effect of the pixel magnification film is equivalent to that of a magnifier, and an excessively large or small magnification effect causes a poor display effect. For example, if the pixel magnification film is excessively far away from a light-emitting region, a magnification effect is good in this case, and such an optical effect can reduce a sparkle problem caused by the anti-glare layer 160. However, excessive scattering (an excessive magnification effect) results in an unclear display image. In addition, if the pixel magnification film is excessively close to the light-emitting region, a good pixel magnification effect cannot be achieved, and a corresponding sparkle problem cannot be well resolved, even if image definition is high in this case.

If the pixel magnification layer 140 is excessively far away from the light-emitting layer 110, an equivalent pixel magnification effect of the pixel magnification layer 140 causes an excessively large pixel image. This can implement lower sparkle, but greatly affects image definition. In contrast, if the pixel magnification layer 140 is excessively close to the light-emitting layer 110, a pixel magnification effect cannot be achieved. This can ensure definition, but cannot achieve a low sparkle effect. Therefore, a specific optimal placement position of the pixel magnification layer 140 needs to be specified based on an optical effect (mainly represented as the internal refractive index difference Δn) of the pixel magnification layer 140 and a distance from the pixel magnification layer 140 to the surface of the light-emitting layer 110, to achieve an optimal laminated architecture design. In addition, the optimization design may be changed accordingly based on an effect of the anti-glare layer 160, to implement a high-definition low-sparkle anti-glare display system design. To achieve an optimal display effect, a specific optical distance (optical distance, OD) is required between the light-emitting layer 110 and the pixel magnification layer 140, so that optimal screen definition and a sparkle suppression effect can be achieved in such a design.

In other words, by controlling a distance between the pixel magnification layer 140 and the encapsulation layer 120, an equivalent pixel magnification effect of light passing through the pixel magnification layer 140 satisfies a minimum requirement for achieving low display sparkle, without excessively compromising display definition, so that the display module 100 has an optimal sparkle and definition effect.

A first distance between the lower surface of the pixel magnification layer 140 and the upper surface of the light-emitting layer 110 is denoted as d. In other words, in a thickness direction of the display module 100, there is a first distance d between the lower surface of the pixel magnification layer 140 and the upper surface of the light-emitting layer 110. It should be understood that the product of the first distance d and the first refractive index difference Δn is within the preset range.

It should be understood that the light-emitting layer 110 may include a substrate, a drive circuit (for example, a thin film transistor drive circuit), an anode layer, a light-emitting unit, and a cathode layer that are stacked. If an uppermost layer of the light-emitting layer 110 is the cathode layer, the first distance between the lower surface of the pixel magnification layer 140 and the upper surface of the light-emitting layer 110 may be considered as a distance between the lower surface of the pixel magnification layer 140 and an upper surface of the cathode layer of the light-emitting layer 110. If the uppermost layer of the light-emitting layer 110 is another structure layer, the first distance between the lower surface of the pixel magnification layer 140 and the upper surface of the light-emitting layer 110 may be considered as a distance between the lower surface of the pixel magnification layer 140 and an upper surface of the another structure layer of the light-emitting layer 110.

For example, the product of the first distance d and the first refractive index difference Δn satisfies the following relationship: Δn*d=15 µm to 200 µm. It should be understood that the first distance d is a sum of thicknesses of the encapsulation layer 120 and the first light transmission layer 130, and the thickness of the encapsulation layer 120 is usually fixed. Therefore, the first distance may be increased or decreased by adjusting the thickness of the first light transmission layer 130. In other words, when the first distance d needs to be increased, the thickness of the first light transmission layer 130 may be increased; or when the first distance d needs to be decreased, the thickness of the first light transmission layer 130 may be decreased.

For example, an overall thickness of the pixel magnification layer 140 may range from 20 µm to 400 µm. It should be understood that the pixel magnification layer 140 has a pixel magnification effect, a circumscribed circle of a magnified pixel has an area A1, an original pixel has an area A0, and A1 and A0 satisfy the following relationship: 1.3*A0≤A1≤3*A0. The pixel herein refers to a single pixel, and the pixel magnification effect may be identified through image shooting by using a microscope.

The anti-glare layer 160 is located on the second light transmission layer 150, and is configured to improve visual experience and reduce external light interference.

As described in FIG. 1A and FIG. 1B, the anti-glare (anti-glare, AG) layer 160 changes a physical characteristic of the surface of the screen, so that the screen has a specific diffuse reflection effect, to disperse reflected light and reduce a glare effect caused by direct light. For example, tiny concave-convex textures are obtained through processing on the surface of the screen. These microstructures may scatter incident light to various directions instead of reflecting the incident light in a centralized manner. In this way, even in a strong light environment, visual interference caused by screen reflection to a user can be reduced, to improve visibility. It should be understood that the surface processing of the AG layer 160 may be usually roughening on a surface of glass or plastic by using a process like chemical etching or sandblasting.

In some examples, the anti-glare layer 160 may be a structure with an uneven surface. Surface roughness Ra of the anti-glare layer 160 ranges from 100 nm to 350 nm, and an overall thickness of the anti-glare layer 160 ranges from 5 µm to 5000 µm.

For example, the anti-glare layer 160 may be an uneven structure that is formed on a surface of glossy glass through chemical etching or the like. For content of this part, refer to FIG. 1A.

For another example, as shown in FIG. 7, the anti-glare layer 160 may include an anti-glare substrate 161 and an anti-glare structure 162. For example, the anti-glare substrate 161 may be made of a PMMA material, and the anti-glare structure 162 may be made of a PC material. The PC may be hot-pressed on the PMMA through nanoimprinting. In this way, the anti-glare structure 162 formed on a surface of the anti-glare layer 160 may cause diffuse reflection of incident light. For content of this part, refer to FIG. 1B.

In some other examples, the anti-glare layer 160 may be a structure having an even or basically even surface but doped with particles inside. The doped particles inside the anti-glare layer 160 may be metal or a metal oxide, for example, Ti, Zr, Si, SiO₂, TiO₂, or ZrO₂; or may be an organic polymer, for example, polytetrafluoroethylene

(polytetrafluoroethylene, PTFE), PMMA, or PC. For example, an average particle size of the doped particles inside the anti-glare layer 160 ranges from 200 nm to 2000 nm, and an overall thickness of the anti-glare layer 160 ranges from 1000 nm to 5000 nm.

For example, a transmittance of the anti-glare layer 160 may be greater than or equal to 85%. In an example, the transmittance of the anti-glare layer 160 may be greater than or equal to 90%. In an example, the transmittance of the anti-glare layer 160 may be greater than or equal to 95%. The transmittance herein may be a light transmittance measured in a single-layer anti-glare structure in which a light source is incident from air, passes through the anti-glare layer 160, and is emitted to the air.

For example, an average transmittance haze of the anti-glare layer 160 may range from 5% to 35%. It should be understood that the average transmittance haze may be understood as an average value of transmittance hazes. By limiting the transmittance and the average transmittance haze of the anti-glare layer 160, light is not excessively scattered when passing through the anti-glare layer 160, thereby avoiding affecting image definition.

It should be noted that an anti-glare capability indicator of the anti-glare layer 160 may be a bidirectional reflectance distribution function (bidirectional reflectance distribution function, BRDF), or may be referred to as an anti-glare BRDF quantity or an anti-glare BRDF value. The BRDF describes energy distribution, in different directions, of reflected light generated within a reflection range (a hemisphere) when collimated incident light is incident to a plane at a specific angle (for example, an incident angle is 0°, that is, vertical incident). As one of physical quantities that describe light intensity distribution of reflected light after light is scattered on a surface of an object, the BRDF may describe an anti-glare degree of the surface of the anti-glare layer 160. The BRDF is in a unit of 1/solid angle (namely, sr⁻¹). The anti-glare BRDF value means attenuation of a value at a 1° angle compared with a value at a 0° angle (normal viewing angle). For example, if BRDF (0°)=X, and BRDF (1°)=Y, the anti-glare BRDF value=(X-Y)/X.

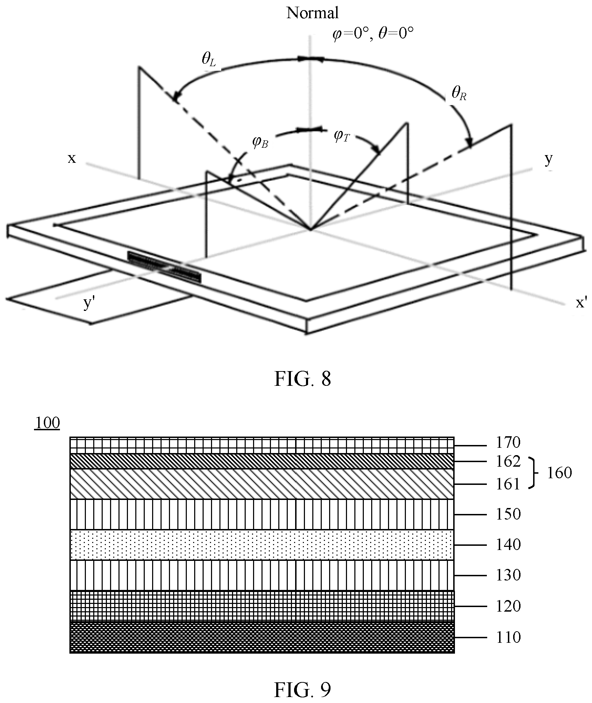

For example, as shown in FIG. 8, a formula for calculating the anti-glare BRDF value may be as follows: $BRDF = 1 - \frac{{BRDF}_{θL} \left(1°\right) + {BRDF}_{θR} \left(1°\right) + {BRDF}_{φT} \left(1°\right) + {BRDF}_{φB} \left(1°\right)}{4 ∗ BRDF \left(0°\right)}$

*BRDF_{θL}* (1°) indicates a BRDF value when an included angle between a normal direction and a positive direction of an x-axis (namely, an x direction) is 1°, *BRDF_{θR}* (1°) indicates a BRDF value when an included angle between the normal direction and a negative direction of the x-axis (namely, an x' direction) is 1°, *BRDF_{φT}* (1°) indicates a BRDF value when an included angle between the normal direction and a positive direction of a y-axis (namely, a y direction) is 1°, *BRDF_{φB}* (1°) indicates a BRDF value when an included angle between the normal direction and a negative direction of the y-axis (namely, a y' direction) is 1°, and *BRDF* (0°) indicates a BRDF value in a normal direction.

It should be understood that a rougher surface of the anti-glare layer 160 indicates a smaller anti-glare BRDF value, and a smoother surface of the anti-glare layer 160 indicates a larger anti-glare BRDF value.

For example, in this application, the anti-glare BRDF value of the anti-glare layer 160 may be less than or equal to 10%. In an example, the anti-glare BRDF value of the anti-glare layer 160 may be less than or equal to 7%. In another example, the anti-glare BRDF value of the anti-glare layer 160 may be less than or equal to 5%.

In some embodiments, as shown in FIG. 9, the display module 100 may further include an anti-reflection layer 170. The anti-reflection layer 170 may be disposed on the anti-glare layer 160, that is, the anti-reflection layer 170 is located on a side of the anti-glare layer 160 that is away from the light-emitting layer 110. A total thickness of the anti-reflection layer 170 is less than 2 µm.

It should be understood that the anti-reflection (anti-reflection, AR) layer 170 is mainly intended to reduce a reflectivity of the surface of the screen, so that external light can penetrate the screen or be scattered more when being irradiated on the screen, instead of being directly reflected back to eyes of a viewer. In this way, a specular reflection effect caused by ambient light can be reduced, so that screen content is clearer in various lighting conditions. The AR layer 170 is usually implemented by plating one or more layers of transparent thin films on the surface of the screen. Thicknesses of these thin films are accurately calculated, so that reflected light waves may cancel each other by using an optical interference principle.

For example, the anti-reflection layer 170 may be a planar coating with a plurality of layers of inorganic materials, or may be a single-layer structure with a sub-wavelength (a wavelength less than 450 nm) structure size. This is not limited in this application.

In some embodiments, as shown in FIG. 10, the display module 100 may further include an oleophobic coating 180. The oleophobic coating 180 may be disposed on the anti-reflection layer 170, that is, the oleophobic coating 180 may be disposed on a side that is of the anti-reflection layer 170 and that is away from the light-emitting layer 110. Alternatively, when the anti-reflection layer 170 is not disposed, the oleophobic coating 180 may be disposed on the anti-glare layer 160, that is, the oleophobic coating 180 may be disposed on the side that is of the anti-glare layer 160 and that is away from the light-emitting layer 110.

It should be understood that the oleophobic coating (oleophobic coating or fingerprint-resistant coating) in the display is a composite material layer specially designed for the surface of the screen. Main functions of the oleophobic coating 180 are as follows:
1. Anti-fingerprint and easy cleaning: The oleophobic coating 180 has a low surface energy feature, which means that the oleophobic coating 180 can repel oil stains and other liquids, so that fingerprints, oil stains, sweat stains, and the like are not easily attached to the screen, to keep the screen clean. Even if the surface of the screen is stained with oil, it is easy to clean the screen with a soft and clean cloth, and no strong detergent is required.
2. Improving a touch sense: The oleophobic coating 180 is usually thin, but can provide a smooth touch sense, making it smoother for a finger to slide on the screen, reducing friction, and improving touch operation experience.
3. Protecting the screen: Although the oleophobic coating 180 is mainly for liquids and grease, the oleophobic coating 180 can also prevent adhesion of dust particles to a specific extent, reducing physical wear on the screen. However, it should be noted that the coating is fragile, and long-time use or improper cleaning (for example, wiping with a sharp object) may cause the coating to wear or pell off.
4. Prolonging a service life: By reducing stain accumulation in daily use, the oleophobic coating 180 helps prolong visual definition and overall aesthetics of the display, and delay a screen aging process caused by frequent cleaning.

It should be noted that, although the oleophobic coating 180 brings many benefits to the display, the oleophobic coating 180 is not permanently effective. As time and use frequency increase, an effect of the coating gradually weakens, and a screen protective film needs to be regularly maintained or replaced to maintain an optimal state.

The following describes in detail cross-sectional structures of the display module in the POL architecture and the CoE architecture in embodiments of this application with reference to FIG. 11 and FIG. 12.

In some POL architectures, the display module 100 may include the light-emitting layer 110, the encapsulation layer 120, a finger touch sensing layer 190, the first light transmission layer 130, the pixel magnification layer 140, the second light transmission layer 150, the anti-glare layer 160, the anti-reflection layer 170, and the oleophobic coating 180 that are stacked in the light-emitting direction. The first light transmission layer 130 may include the bonding layer 131, the polarizer 132, and the bonding layer 133 that are stacked in the light-emitting direction, and the second light transmission layer 150 may be an bonding layer. Alternatively, the first light transmission layer 130 may be an bonding layer, and the second light transmission layer 150 may include the bonding layer 151, the polarizer 152, and the bonding layer 153 that are stacked in the light-emitting direction.

For example, as shown in FIG. 11, the display module 100 may include the light-emitting layer 110, the encapsulation layer 120, the finger touch sensing layer 190, the bonding layer 131, the polarizer 132, the bonding layer 133, the pixel magnification layer 140, the second light transmission layer 150, the anti-glare layer 160, the anti-reflection layer 170, and the oleophobic coating 180 that are stacked in the light-emitting direction. The light-emitting layer 110 may include a substrate, a drive circuit, an anode layer, a light-emitting unit, a cathode layer, and the like. In this case, the first distance d between the lower surface of the pixel magnification layer 140 and the upper surface of the light-emitting layer 110 may be considered as the distance between the lower surface of the pixel magnification layer 140 and the upper surface of the cathode layer of the light-emitting layer 110.

In some CoE architectures, as shown in FIG. 12, the display module 100 may include the light-emitting layer 110, the encapsulation layer 120, the finger touch sensing layer 190, the light filter film 200, a third light transmission layer 220, a cover 210, the first light transmission layer 130, the pixel magnification layer 140, the second light transmission layer 150, the anti-glare layer 160, the anti-reflection layer 170, and the oleophobic coating 180 that are stacked in the light-emitting direction. Both the first light transmission layer 130 and the second light transmission layer 150 are bonding layers. The light-emitting layer 110 may include a substrate, a drive circuit, an anode layer, a light-emitting unit, a cathode layer, and the like. In this case, the first distance d between the lower surface of the pixel magnification layer 140 and the upper surface of the light-emitting layer 110 may be considered as the distance between the lower surface of the pixel magnification layer 140 and the upper surface of the cathode layer of the light-emitting layer 110.

It should be understood that for parts that are not described in detail in FIG. 11 and FIG. 12, refer to the content described in FIG. 2 to FIG. 10. Details are not described herein again.

In addition, an embodiment of this application further provides an electronic device. The electronic device has a display module (or a display), and the display module may be the display module 100 described in FIG. 2 to FIG. 12.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A display module, comprising a light-emitting layer (110), an encapsulation layer (120), a first light transmission layer (130), a pixel magnification layer (140), a second light transmission layer (150), and an anti-glare layer (160) that are stacked in a light-emitting direction, wherein
the pixel magnification layer (140) has a first material and a second material, the first material has a first refractive index, the second material has a second refractive index, and a difference between the first refractive index and the second refractive index is a first refractive index difference; and a distance between a lower surface of the pixel magnification layer (140) and an upper surface of the light-emitting layer (110) is a first distance, and a product of the first distance and the first refractive index difference ranges from 15 µm to 200 µm.

2. The display module according to claim 1, wherein a value range of the first refractive index difference is 0.005 to 0.4.

3. The display module according to claim 1 or 2, wherein the pixel magnification layer (140) is configured to magnify a pixel, and an area of a magnified pixel is 1.3 times to 3 times of an area of the original pixel.

4. The display module according to any one of claims 1 to 3, wherein the first light transmission layer (130) comprises a first bonding layer (131), a first polarizer (132), and a second bonding layer (133) that are stacked in the light-emitting direction; and
the first bonding layer (131) is located between the encapsulation layer (120) and the first polarizer (132), and the second bonding layer (133) is located between the first polarizer (132) and the pixel magnification layer (140).

5. The display module according to any one of claims 1 to 4, wherein the second light transmission layer (150) comprises a third bonding layer (151), a second polarizer (152), and a fourth bonding layer (153) that are stacked in the light-emitting direction; and
the third bonding layer (151) is located between the pixel magnification layer (140) and the second polarizer (152), and the fourth bonding layer (153) is located between the second polarizer (152) and the anti-glare layer (160).

6. The display module according to any one of claims 1 to 3, wherein the display module further comprises a light filter film (200), and the light filter film (200) is located between the encapsulation layer (120) and the first light transmission layer (130).

7. The display module according to claim 6, wherein the display module further comprises a cover (210) and a third light transmission layer (220), the third light transmission layer (220) is located between the cover (210) and the light filter film (200), and the cover (210) is located between the third light transmission layer (220) and the first light transmission layer (130).

8. The display module according to claim 6 or 7, wherein both the first light transmission layer (130) and the second light transmission layer (150) are bonding layers configured to bond upper and lower layers.

9. The display module according to any one of claims 1 to 8, wherein the light-emitting layer (110) comprises a plurality of light-emitting units, and the plurality of light-emitting units use a tandem design.

10. The display module according to any one of claims 1 to 9, wherein the anti-glare layer (160) comprises an anti-glare substrate (161) and an anti-glare structure (162), and the anti-glare substrate (161) is located between the second light transmission layer (150) and the anti-glare structure (162).

11. The display module according to any one of claims 1 to 10, wherein a surface of the anti-glare layer (160) is uneven, and roughness of the anti-glare layer (160) ranges from 100 nm to 350 nm.

12. The display module according to any one of claims 1 to 10, wherein a surface of the anti-glare layer (160) is even, the anti-glare layer (160) is doped with particles inside, and an average particle size of the doped particles inside the anti-glare layer (160) ranges from 200 nm to 2000 nm.

13. The display module according to any one of claims 1 to 12, wherein a transmittance of the anti-glare layer (160) is greater than or equal to 85%, and an average transmittance haze of the anti-glare layer (160) ranges from 5% to 35%.

14. The display module according to any one of claims 1 to 13, wherein an average transmittance haze of the first light transmission layer (130) and/or the second light transmission layer (150) is less than or equal to 5%.

15. An electronic device, comprising the display module according to any one of claims 1 to 14.
